# EUROPEAN PATENT APPLICATION

(11) **EP 2 042 580 A1**
(43) Date of publication of application: **01.04.2009**
(21) Application number: 06767886.2
(22) Date of filing: 05.07.2006
(51) Int. Cl.: C09J 201/00

(54) **CONDUCTIVE ADHESIVE**

(71) Applicant: Ablestik (Japan) Co., Ltd., Atsugi-shi, Kanagawa 243-0807 (JP); Namics Corporation, Niigata-shi, Niigata 950-3131 (JP)
(72) Inventor: WATANABE, Bunya, Nigata-shi, Nigata 950-0917 (JP); TOIDA, Go, Niigata-shi, Niigata 950-3131 (JP)
(74) Representative: Hart-Davis, Jason
(86) International application number: PCT/JP2006/313380
(87) International publication number: WO 2008/004287

(57) **Abstract**

Conductive adhesives, which do not have the problem of migration in conductive metals upon application of a voltage and which exhibit low resistance values, are provided.

One embodiment of the present invention relates to a conductive adhesive comprising a conductive filler and a resin, **characterized in that** the conductive filler comprises an alloy powder of silver and tin and further contains an additive comprising at least one member selected from among a chelator, an antioxidant, and a metal surfactant. Additives that can be used are chelators such as hydroxyquinolines, salicylidene aminothiophenols or phenanthrolines, antioxidants such as hydroquinones or benzotriazoles, and metal surfactants such as organic acids, acid anhydrides or organic acid salts.

## Description

### TECHNICAL FIELD

The present invention relates to conductive adhesives and, more particularly, to conductive adhesives that can be used in packaging electronic components such as semiconductor devices by connecting them onto substrates.

### BACKGROUND ART

For packaging electronic components, flip-chip solder bonding and the like have conventionally been adopted to connect them to electrodes on substrate surfaces. However, solder is a lead-tin alloy and if the solder used in discarded electronic equipment is dissolved by acid rain, it might dissolve into the underground water to present a potential impact on the environment. As a lead-free packaging technology, it has been proposed that a conductive adhesive be used instead of the conventional solder in connecting substrate electrodes to electronic components. A further problem with the use of solder in connecting substrate electrodes to electronic components is that if cyclic stresses are applied, failure occurs from metal fatigue, occasionally causing cracks in connections. In contrast, when the conductive adhesive is used to connect substrate electrodes to electronic components, the connections are bonded by the resin and this offers the advantage of flexibility in coping with deformation. Thus, the method of packaging electronic components with the conductive adhesive is advantageous not only in the environmental aspect but also in terms of connection reliability and, hence, it is drawing particular attention in recent years.

Conductive adhesives generally comprise a base resin such as an epoxy resin, an acrylic resin, a polyester resin and a phenolic resin that has the particles of a conductive metal such as silver, copper and nickel dispersed in it as a conductive filler. Recently, in the field of packaging electronic components, a technique is being employed to screen print the conductive adhesive in the circuit area on the substrate and bond electronic components in their specified positions; the above-described conductive adhesives also find use in this field. However, with the ever-increasing progress that is being made in the miniaturization of electronic equipment these days, it is required to perform ultra-fine screen printing of those conductive adhesives.

Silver, the most common conductive filler, involves the problem of migration upon application of a voltage and this problem is substantial in the case of printing the conductive adhesive on the substrate by fine-line screen printing. Under the circumstances, it has been proposed to use a silver-tin alloy powder as the conductive filler (Patent Document 1). Use of this silver-tin alloy powder filler dissolves the problem of migration but then its high resistance value prevents it from attaining a practically feasible level of performance when used in packaging electronic components onto substrate electrodes. With a view to solving this problem of high resistance values, it has been proposed that the powder of a low-melting alloy, for example, a tin-bismuth alloy, be added to the silver-tin filler; however, this approach is not adequately effective in reducing the contact resistance and, what is more, the addition of the tin-bismuth alloy powder requires temperatures as high as about 180°C to cure the adhesive.
Patent Document 1: JP 2002-265920 A
Patent Document 2: USP 6344157
Patent Document 3: USP 6583201

### DISCLOSURE OF THE INVENTION

### PROBLEMS TO BE SOLVED BY THE INVENTION

An object of the present invention is to solve the above-described problems by providing conductive adhesives that do not have the problem of migration in conductive metals upon application of a voltage and which exhibit low resistance values.

### MEANS FOR SOLVING THE PROBLEMS

As a means for solving the above-stated object, there is provided in an embodiment of the present invention a conductive adhesive comprising a conductive filler and a resin, **characterized in that** the conductive filler comprises an alloy powder of silver and tin and further contains an additive comprising at least one member selected from among a chelator, an antioxidant, and a metal surfactant.

The conductive adhesive of the present invention is characterized by adding at least one member selected from among a chelator, an antioxidant, and a metal surfactant to a resin (base resin) and silver-tin filler system as an additive for lowering the value of contact resistance.

### BRIEF DESCRIPTION OF THE DRAWING

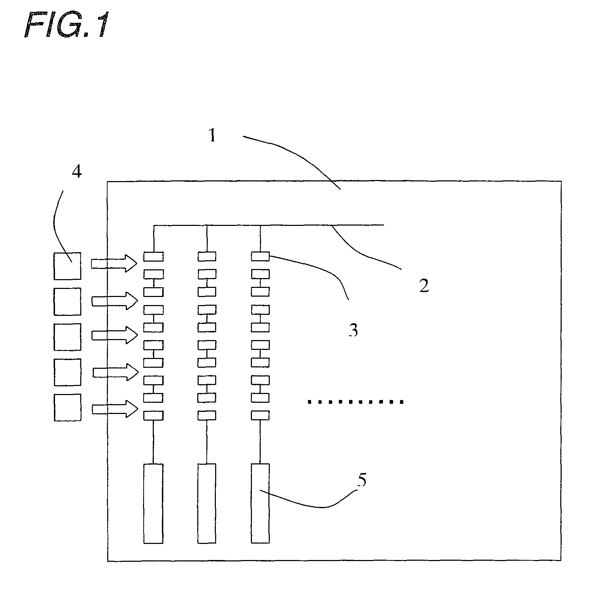

[FIG. 1] FIG. 1 is a diagram showing the layout of the test piece used in the Examples for contact resistance measurement.

### EXPLANATION OF THE REFERENCE NUMERALS

- 1:: FR4 substrate
- 2:: daisy chain pattern
- 3:: electrodes on the FR4 circuit board
- 4:: 0 Ω chip resistor
- 5:: measuring electrode pad

### BEST MODES FOR CARRYING OUT THE INVENTION

Examples of the additive that can be added in the present invention to lower the contact resistance value include hydroxyquinolines, salicylidene aminothiophenols, and phenanthrolines as chelators. Specific examples include quinoline derivatives such as 8-hydroxyquinoline (8-HQL) of the following formula 1, 6-hydroxyquinoline and 2-hydroxyquinoline, as well as salicylideneamino-2-thiophenol of the following formula 2, and 1,10-phenanthroline of the following formula 3.

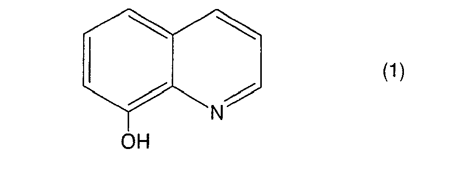

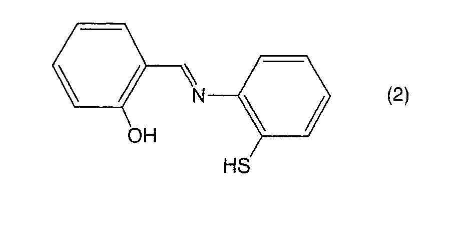

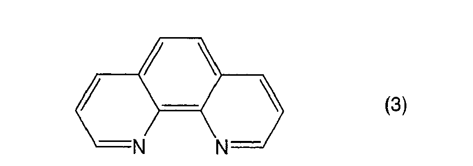

As antioxidants, hydroquinones and benzotriazoles may be incorporated in the conductive adhesive according to the present invention and used as an additive for lowering its contact resistance. Specifically, 1,4-dihydroxybenzene (HQ) (the following formula 4), 1,2-dihydroxybenzene and 1,3-dihydroxybenzene may be used as exemplary hydroquinones, and benzotriazole of the following formula 5, 2-(5-methyl-2-hydroxyphenyl)benzotriazole, 2-(3,5-di-t-butyl-2-hydroxyphenyl)benzotriazole, and 2-(3,5-di-t-amyl-2-hydroxypenyl)benzotriazole may be used as exemplary benzotriazoles.

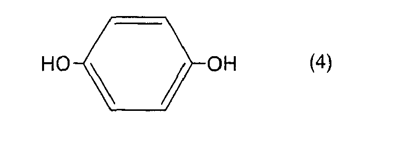

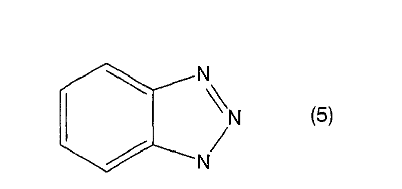

As metal surfactants, organic acids, acid anhydrides or organic acid salts may be used. Specifically, one may use: organic acids such as neododecanoic acid, lactic acid, citric acid, oleic acid, glutamic acid, benzoic acid, oxalic acid, abietic acid, adipic acid and stearic acid; acid anhydrides such as methyltetrahydrophthalic anhydride (Me-THPA) of the following formula 6, methylhexahydrophthalic anhydride (MHHPA), methyl-ento-methylenetetrahydrophthalic anhydride (NMA), himic anhydride, succinic anhydride, trimellitic anhydride and pyromellitic anhydride; and organic acid salts such as 1,8-diazabicyclo(5,4,0)undec-7-ene/2-ethyl hexanoate of the following formula 7 (where R represents -C(=O)CH(C₂H₅)CH₂CH₂CH₂CH₃), and tri-n-butyldodecylphosphonium 2-(benzotriazol-1-ylcarbonyl)-4-methylcyclohexane-1-carboxylate (PX-412MCH) of the following formula 8.

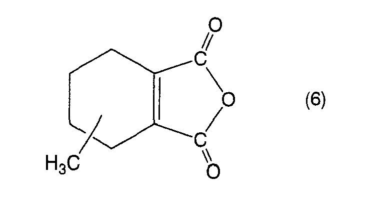

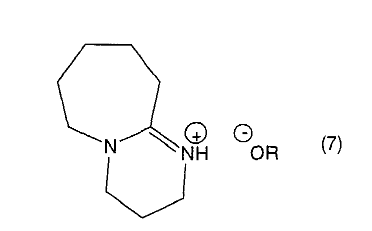

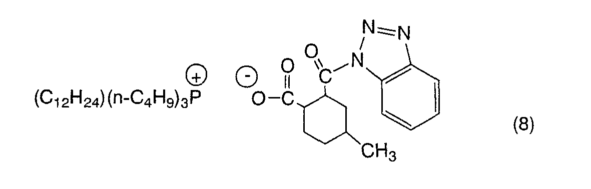

It has been proposed that these compounds be used in the silver filler incorporating conductive adhesives as corrosion inhibitors that can suppress the tendency of the contact resistance value to increase gradually in a humidity resistance test with electronic components that are packaged with tin or tin-lead systems being used as electrodes (see Patent Documents 2 and 3 listed above). However, to the best knowledge of the present inventors, there has been no case whatsoever of using those compounds as additives for lowering the contact resistance value (initial resistance value) in conductive adhesives that incorporate the silver-tin alloy powder filler.

The conductive filler in the conductive adhesive of the present invention comprises the silver-tin alloy powder. Specifically, it suffices that at least 40 wt% of the conductive filler is composed of the silver-tin alloy powder. Components that may be used other than the silver-tin alloy powder in the conductive filler include a silver powder, a tin powder, a bismuth powder, an indium powder, as well as the powders of alloys and/or mixtures of these metals. If these components are to be used, their amount is preferably no more than 25 wt% of the silver-tin alloy powder.

Note that if the conductive filler is substantially composed of the silver-tin alloy powder and an another alloy powder such as a tin-bismuth or indium-tin alloy powder that has a lower melting point than the curing temperature, there is obtained a greater effect for lowering the contact resistance value of the conductive adhesive. Therefore, in applications where it is particularly required to lower the contact resistance value of the conductive adhesive, the combination of the silver-tin alloy powder and the alloy powder having a lower melting point than the curing temperature is preferably used as the conductive filler. The problem is that if the alloy powder having a lower melting point than the curing temperature is added as a component of the conductive filler, the contact resistance value of the conductive adhesive is greatly lowered but that at the same time, the mechanical strength of the conductive adhesive drops. Therefore, in applications where it is particularly required to maintain the mechanical strength of the conductive adhesive at high level, it is preferred that the conductive filler component of the conductive adhesive is substantially composed of the silver-tin alloy powder and does not contain any alloy powder that has a lower melting point than the curing temperature. It should also be noted that if a tin-bismuth alloy powder having a lower melting point than the curing temperature is used as a component of the conductive filler, no sufficient conductivity is obtained for the conductive adhesive unless it is cured at about 180°C which is considerably higher than the melting point of the tin-bismuth alloy.

The silver-tin alloy powder that can be used as a component of the conductive filler in the present invention may typically be obtained by the following process: silver and tin are mixed to give a desired molar ratio and melted, with the melt being then ejected into an inert atmosphere to form an alloy powder (an atomization method), and alloy particles not larger than a desired size are collected. If desired, the powder formed by the above-described atomization method may be vaporized in a plasma furnace and then cooled to solidify to yield an alloy powder. Alternatively, a silver powder as mixed with a tin powder may be alloyed by heating by any suitable means so as to obtain a silver-tin alloy powder. The tin-bismuth alloy powder may be obtained in the same way.

The shape of the alloy powders that can be used in the present invention is not limited in any particular way and examples include but are not limited to spherical, flaky, acicular, and dendritic shapes. The size of the alloy powders may range from 0.1 to 30 µm, or from 1 to 20 µm in terms of the diameter (average diameter) of its particles.

The conductive adhesive of the present invention preferably contains the conductive filler in an amount ranging from 60 to 98 wt%, more preferably from 70 to 95 wt%, of the sum of the resin component and the conductive filler.

In the conductive adhesive of the present invention, the resin component (base resin) may be either thermoplastic or thermosetting. Exemplary thermoplastic resins include acrylic resins, ethyl cellulose, polyesters, polysulfones, phenoxy resins, and polyimide resins; exemplary thermosetting resins include amino resins such as urea resins, melamine resins and guanamine resins, bisphenol A, bisphenol F, phenol novolacs, alicyclic epoxy resins, oxetane resins, phenolic resins, and silicone-modified resins such as silicone epoxy resins and silicone polyester resins. These resins may be used in combination of two or more species.

The above-described additive(s) for lowering the contact resistance of the conductive adhesive may be mixed with the resin, conductive filler and other components simultaneously; alternatively, the conductive filler as preliminarily surface-treated with the additive(s) may be mixed with the resin and other components. In this case, the conductive filler may be surface-treated with the additive(s) by such methods as adding the additive(s) while the conductive filler is being processed into flakes or dissolving the additive(s) in an organic solvent, immersing the conductive filler in the solution, and removing the organic solvent by vaporization.

If an epoxy resin is used as the base resin for the conductive adhesive according to the present invention, it may be a self-curing epoxy resin, or it may have a curing agent or a cure accelerator such as amines, imidazoles, acid anhydrides or onium salts incorporated therein, or an amino resin or a phenolic resin may be incorporated as a curing agent for epoxy resins.

In the conductive adhesive according to the present invention, the resin is preferably incorporated in an amount ranging from 2 to 40 wt%, more preferably from 5 to 30 wt%, of the sum of the resin and the conductive filler.

The conductive adhesive according to the present invention may have a diluent incorporated therein depending on the need. Organic solvents may be used as the diluent and, in a particular case where the resin is an epoxy resin, a reactive diluent may be employed.

Organic solvents may be chosen depending on the type of the resin. Organic solvents may be exemplified by: aromatic hydrocarbons such as toluene, xylene, mesitylene, and tetralin; ethers such as tetrahydrofuran; ketones such as methyl ethyl ketone, methyl isobutyl ketone, cyclohexanone, and isophorone; lactams such as 2-pyrrolidone and 1-methyl-2-pyrrolidone; ether alcohols such as ethylene glycol monomethyl ether, ethylene glycol monoethyl ether, ethylene glycol monobutyl ether, diethylene glycol monomethyl ether, diethylene glycol monoethyl ether, diethylene glycol monobutyl ether, as well as their corresponding propylene glycol derivatives; their corresponding esters such as acetates; and diesters such as methyl ester or ethyl ester of dicarboxylic acids such as malonic acid and succinic acid. The amount in which the organic solvents are used can be chosen at desired values depending on such factors as the types and relative quantities of the conductive filler and the resin (base resin) that are employed, and the method of printing or coating the conductive adhesive.

If the conductive adhesive according to the present invention needs to form a desired pattern by printing or coating or to be given a suitable degree of fluidity that enables it to fill details or if there is a need to prevent the applied conductive adhesive from thinning out or deteriorating the working environment on account of the evaporation of the solvent, part or all of the diluent may be occupied by a reactive diluent. Reactive diluents may be exemplified by: diglycidyl compounds such as polyethylene glycol diglycidyl ether, poly(2-hydroxypropylene)glycol diglycidyl ether, polypropylene glycol diglycidyl ether, butanediol diglycidyl ether, neopentyl glycol diglycidyl ether, diglycidyl aniline, 1,4-cyclohexane dimethanol diglycidyl ether, and 1,3-bis(3-glycidoxypropyl)-1,1,3,3-tetramethyldisiloxane; and triglycidyl compounds such as trimethylolpropane triglycidyl ether and glycerin triglycidyl ether; depending on the need, these compounds may be used in combination with reactive diluents of a monoglycidyl ether type such as n-butyl glycidyl ether, allyl glycidyl ether, and glycidyl methacrylate. If organic solvents are not used but reactive diluents alone are used as the diluent, solvent removal may be replaced by polymerizing and curing the reactive diluents under appropriate conditions so that they can be incorporated into the conductive layer.

In addition to the above, the conductive adhesive according to the present invention may have a dispersion aid incorporated therein depending on the need; exemplary dispersion aids include: aluminum chelate compounds such as diisopropoxy(ethyl acetoacetato)aluminum; titanic acid esters such as isopropyl triisostearoyl titanate; aliphatic polyvalent carboxylic acid esters; unsaturated aliphatic acid amine salts; surfactants such as sorbitan monooleate; and polymeric compounds such as polyester amine salts and polyamides. If desired, inorganic or organic pigments, silane coupling agents, leveling agents, thixotropic agents, antifoamers, and the like may be incorporated.

The conductive adhesive according to the present invention can be prepared by uniformly mixing the ingredients by a suitable mixing means such as a mortar, a propeller agitator, a kneader, a roller assembly, or a pot mill. The temperature for preparation is not limited in any particular way and preparation may be performed at ordinary temperatures.

The conductive adhesive according to the present invention can be printed or coated on a substrate by any desired method such as stencil printing, screen printing, gravure printing, or dispensing. The conductive adhesive according to the present invention may be employed for a particular case of applying a pattern of the adhesive onto a substrate by fine-line stencil printing.

Thus, using the conductive adhesive according to the present invention, electronic components such as semiconductor devices, chip components, discrete components or combinations thereof may be joined to electrodes on a circuit board to thereby form an electronic circuit on the board's surface.

### EXAMPLES

The present invention is described more specifically by means of the following examples. It should be noted that the present invention is by no means limited by the following description.

### Examples 1 to 11 and Comparative Examples 1 to 3

To prepare thermosetting resin compositions, an epoxy resin (product of Tohto Kasei Co., Ltd.; trade name, ZX1059), a latent curing agent (product of AJINOMOTO FINE-TECHNO CO., INC.; PN-H), the cure accelerator imidazole of SHIKOKU CHEMICALS CORPORATION (trade name, 2P4MHZ), and a silane coupling agent (product of DOW CORNING TORAY SILICONE CO., LTD.; trade name SH6040) were incorporated in the proportions indicated in Tables 1 and 2. The following materials were added in the amounts indicated in Tables 1 and 2: the diluent butyl carbitol acetate (BCaA); the compounds shown in Tables 1 and 2 as an additive for lowering the contact resistance value; and a silver-tin alloy powder filler (silver:tin = 65:35; particle size, 15 µm), either alone or mixed with a tin-bismuth alloy powder (tin:bismuth = 42:58; particle size, 15 µm) in an amount of 5 wt% of the silver-tin alloy powder filler; these materials were mixed with the thermosetting resin compositions to prepare adhesive compositions, which were cured by heating at 150°C for 10 minutes. In Comparative Example 3, heating at 150°C for 10 minutes was incapable of providing sufficient conductivity, so curing was done at 180°C for 30 minutes. The respective thermosetting adhesive compositions were measured for their contact resistance values and joint strengths. The results are shown in Tables 1 and 2. In Table 1, the relative proportions of the incorporated components are indicated in terms of parts by weight.

To measure the contact resistance values of the cured adhesive compositions, a test piece of the configuration shown in FIG. 1 was used. An FR4 substrate 1 was copper plated to form a daisy chain pattern 2; electrodes 3 on the FR4 circuit board (copper pads coated with OSP (organic solderable protective film)) were covered with the conductive adhesive compositions (see above) that were applied by stencil printing using a metal mask 70 µm thick. On the printed areas, 2012-sized, 0 Ω chip resistors 4 having an external tin electrode were mounted and cured in an oven under the above-mentioned conditions to prepare the test piece. The contact resistance between the terminals of adjacent measuring electrode pads 5 on the prepared FR4 circuit was measured by the four-terminal method. The resistance values indicated in Tables 1 and 2 each represent the value per contact area (i.e., a twentieth of the resistance value as read on a decade).

For the joint strength, the conductive adhesive compositions as prepared above were applied to the FR4 substrate by stencil printing; on the printed areas, the same 0 Ω chip resistors were mounted and cured in an oven under the above-mentioned conditions to prepare a test piece, which was then measured for its die shear strength.

According to the present invention, the addition of the specified additives for lowering the contact resistance enabled substantial reduction in the contact resistance of the conductive adhesive that used the silver-tin alloy powder as the conductive filler and, as a result, the conductive adhesive acquired a practically feasible level of performance for use in packaging electronic components.

**Table 1: Test Results of Examples 1 to 7**

| | | | Example | | | | | | |
|---|---|---|---|---|---|---|---|---|---|
| | | | 1 | 2 | 3 | 4 | 5 | 6 | 7 |
| Thermosetting resin composition | Epoxy resin | | 11.88 | 11.88 | 11.88 | 11.88 | 11.88 | 11.88 | 11.88 |
| | Latent curing agent | | 1.8 | 1.8 | 1.8 | 1.8 | 1.8 | 1.8 | 1.8 |
| | Cure accelerator | | 1.2 | 1.2 | 1.2 | 1.2 | 1.2 | 1.2 | 1,2 |
| | Silane coupling agent | | 0.12 | 0.12 | 0.12 | 0.12 | 0.12 | 0.12 | 0.12 |
| Diluent | BCaA | | | | | 1 | 1 | 3 | |
| Additive | 8-HQL | | 3 | 5 | 0.1 | | | | |
| | Salicylideneamino-2-thiophenol | | | | | 3 | | | |
| | 1,10-Phenanthroline | | | | | | 3 | | |
| | HQ | | | | | | | 3 | |
| | Benzotriazole | | | | | | | | 3 |
| | Neododecanoic acid | | | | | | | | |
| | Me-THPA | | | | | | | | |
| | DBU/ 2-Ethyl hexanoate | | | | | | | | |
| | PX-412MCH | | | | | | | | |
| Filler | AgSn filler | | 85 | 85 | 85 | 85 | 85 | 85 | 85 |
| | AgSn/SnBi | | | | | | | | |
| Curing conditions | | | 150°C × 10min | | | | | | |
| Contact resistance | | (mΩ/joint) | 12 | 11 | 8015 | 2480 | 5995 | 335 | 968 |
| Joint strength | | kgf/chip | 3.13 | 2.99 | 5.56 | 6.22 | 4.51 | 6.71 | 8 |

**Table 2: Test Results of Examples 8 to 11 and Comparative Examples 1 to 3**

| | | | Example | | | | Comparative Example | | |
|---|---|---|---|---|---|---|---|---|---|
| | | | 8 | 9 | 10 | 11 | 1 | 2 | 3 |
| Thermosetting resin composition | Epoxy resin | | 11.88 | 11.88 | 11.88 | 11.88 | 11.88 | 11.88 | 11.88 |
| | Latent curing agent | | 1.8 | 1.8 | 1.8 | 1.8 | 1.8 | 1.8 | 1.8 |
| | Cure accelerator | | 1.2 | 1.2 | 1.2 | 1.2 | 1.2 | 1.2 | 1.2 |
| | Silane coupling agent | | 0.12 | 0.12 | 0.12 | 0.12 | 0.12 | 0.12 | 0.12 |
| Diluent | BCaA | | | | | | | 3 | 3 |
| Additive | 8-HQL | | | | | | | | |
| | Salicylideneamino-2-thiophenol | | | | | | | | |
| | 1,10-Phenanthroline | | | | | | | | |
| | HQ | | | | | | | | |
| | Benzotriazole | | | | | | | | |
| | Neododecanoic acid | | 3 | | | | | | |
| | Me-THPA | | | 3 | | | | | |
| | DBU/ 2-Ethyl hexanoate | | | | 3 | | | | |
| | PX-412MCH | | | | | 3 | | | |
| Filler | AgSn filler | | 85 | 85 | 85 | 85 | 85 | | |
| | AgSn/SnBi | | | | | | | 85 | 85 |
| Curing conditions | | | 150°C × 10min | | | | | | 180°C × 30min |
| Contact resistance | | (mΩ/joint) | 172 | 8965 | 437 | 1770 | 18535 | 71000 | 15335 |
| Joint strength | | kgf/chip | 5.81 | 5.9 | 6.87 | 5.51 | 5.12 | 4.31 | 4.41 |

### Examples 12 to 20 and Comparative Example 4

In these examples and comparative example, the conductive adhesive samples incorporating the additives that would lower the contact resistance value were evaluated for the joint strength in the case of using as a conductive filler the powder of AgSn/SnBi mixed system that was employed in Comparative Examples 2 and 3.

To 23 parts by weight of thermosetting resin compositions (epoxy resin + latent curing agent + cure accelerator + silane coupling agent) that were prepared with the respective components incorporated in the same proportions as in Example 1, the additives shown in Tables 3 and 4 as well as the Ag-Sn alloy powder filler incorporating the Sn-Bi alloy powder were added in the amounts shown in Tables 3 and 4; the compositions and the respective components were mixed to prepare adhesive compositions, which were cured as in Example 1 and measured for their contact resistance and joint strength. The results are shown in Tables 3 and 4.

According to the present invention, the silver-tin alloy powder incorporating the tin-bismuth alloy powder was used as the conductive filler in the conductive adhesive that had added thereto the specified additives for lowering the contact resistance; as a result, the joint strength could be increased with the contact resistance value being held at a practically feasible level although the content of the conductive filler was low. In particular, when 8-HQL was used either alone or in combination with neododecanoic acid or Me-THPA as the additive, the joint strength could be increased with the contact resistance value being held at an extremely low level. Thus, the contact resistance value could be lowered substantially and the conductive adhesive acquired a practically feasible level of performance for use in packaging electronic components.

**Table 3: Test Results of Examples 12 to 16**

| | | Example | | | | |
|---|---|---|---|---|---|---|
| | | 12 | 13 | 14 | 15 | 16 |
| Thermosetting resin composition | | 23 | 23 | 23 | 23 | 23 |
| Additive | 8-HQL | 3 | | | | |
| | HQ | | 3 | | | |
| | Benzotriazole | | | 3 | | |
| | Neododecanoic acid | | | | 3 | |
| | Me-THPA | | | | | 3 |
| | DBU/2-Ethyl hexanoate | | | | | |
| | PX-412MCH | | | | | |
| Filler | AgSn/SnBi | 77 | 77 | 77 | 77 | 77 |
| Contact resistance | mΩ/joint | 17 | 14900 | 3300 | 5800 | 4400 |
| Joint strength | kgf/chip | 3.55 | 4.63 | 5.2 | 3.43 | 4.43 |

**Table 4: Test Results of Examples 17 to 20 and Comparative Example 4**

| | | Example | | | | Comparative Example |
|---|---|---|---|---|---|---|
| | | 17 | 18 | 19 | 20 | 4 |
| Thermosetting resin composition | | 23 | 23 | 23 | 23 | 23 |
| Additive | 8-HQL | | | 2 | 2 | |
| | HQ | | | | | |
| | Benzotriazole | | | | | |
| | Neododecanoic acid | | | 1 | | |
| | Me-THPA | | | | 1 | |
| | DBU/ 2-Ethyl hexanoate | 3 | | | | |
| | PX-412MCH | | 3 | | | |
| Filler | AgSn/SnBi | 77 | 77 | 77 | 77 | 77 |
| Contact resistance | mΩ/joint | 1500 | 1000 | 18 | 12 | 30700 |
| Joint strength | kgf/chip | 5.3 | 4.8 | 3.7 | 2.7 | 3.32 |

### Example 21 and Comparative Example 5

Two parts by weight of 8-HQL was dissolved in 30 parts by weight of acetone; to the resulting solution, 100 parts by weight of the silver-tin alloy powder filler used in Example 1 was immersed and agitated; thereafter, acetone was removed by vaporization so that the silver-tin alloy powder filler was surface treated with 8-HQL. Twenty-three parts by weight of thermosetting resin compositions (epoxy resin + latent curing agent + cure accelerator + silane coupling agent) that were prepared with the respective components incorporated in the same proportions as in Example 1 was mixed with 77 parts by weight of the silver-tin alloy powder filler that had been surface treated with 8-HQL as described above or the silver-tin alloy powder filler that had not received such surface treatment, whereby conductive adhesive compositions were prepared. The conductive adhesives were cured as in Example 1 and their contact resistance and joint strength were measured. The results are shown in Table 5.

In the present invention, the silver-tin alloy powder filler and the silver-tin alloy powder filler which was surface treated with a certain additive for lowering the contact resistance of the conductive adhesive could be added to the resin and other components to prepared a conductive adhesive composition and yet the composition exhibited a satisfactorily low contact resistance value and high joint strength.

**Table 5: Test Results of Example 21 and Comparative Example 5**

| | | Example 21 | Comparative Example 5 |
|---|---|---|---|
| Thermosetting resin composition | | 23 | 23 |
| AgSn filler | Surface treated with 8-HQL | 77 | |
| | No surface treatment | | 77 |
| Contact resistance | mΩ/joint | 8180 | 30660 |
| Joint strength | kgf/chip | 3.4 | 3.3 |

### INDUSTRIAL APPLICABILITY

According to the present invention, a resin-based conductive adhesive is prepared using a silver-tin alloy as a conductive filler and incorporating at least one member selected from among a chelator, an antioxidant and a metal surfactant as an additive for lowering the contact resistance of the conductive adhesive; the conductive adhesive thus prepared is free from the problem of migration of a conductive metal upon application of voltage and when it is cured, its contact resistance value decreases substantially; thus, it exhibits a practically feasible level of performance for use in packaging electronic components.

## Claims

1. A conductive adhesive comprising a conductive filler and a resin, **characterized in that** the conductive filler comprises an alloy powder of silver and tin and further contains an additive comprising at least one member selected from among a chelator, an antioxidant, and a metal surfactant.

2. The conductive adhesive according to claim 1, wherein the chelator is a hydroxyquinoline-class compound, a salicylidene aminothiophenol class compound or a phenanthroline-class compound, the antioxidant is a hydroquinone-class compound or a benzotriazole-class compound, and the metal surfactant is an organic acid, an acid anhydride or an organic acid salt.

3. The conductive adhesive according to claim 1 or 2, which further contains a tin-bismuth alloy powder as a component of the conductive filler.

4. An electronic circuit wherein electronic components are joined to electrodes on a circuit board using the conductive adhesive according to any one of claims 1 to 3.
